# EUROPÄISCHE PATENTSCHRIFT

(11) **EP 0 720 074 B1**
(45) Veröffentlichungstag und Bekanntmachung des Hinweises auf die Patenterteilung: **26.08.1998**
(21) Anmeldenummer: 95119197.2
(22) Anmeldetag: 06.12.1995
(51) Int. Cl.: G05B 19/418

(54) **Informationssystem zur Produktionskontrolle**
Information system for the control of production
Système d'information pour le contrôle de la production

(30) Priorität: 28.12.1994 DE 4446966
(43) Veröffentlichungstag der Anmeldung: 03.07.1996
(73) Patentinhaber: Micronas Intermetall GmbH, 79108 Freiburg (DE)
(72) Erfinder: Samaha, Mustafa, Dipl.-Ing., D-79104 Freiburg (DE)

(56) Entgegenhaltungen:
- WO-A-93/25945
- US-A- 5 245 704
- US-A- 5 355 320
- ADVANCES IN INSTRUMENTATION AND CONTROL, Bd. 48, Nr. PART 03, 1.Januar 1993 Seiten 1557-1564, XP 000428426 NAOKI URA ET AL 'REMOTE MAINTENANCE FUNCTION FOR DISTRIBUTED CONTROL SYSTEM'

## Beschreibung

Die Erfindung betrifft ein Informationssystem zur schnellen Produktionskontrolle, bei dem aus vielen Meß- und Testbereichen die Meßdaten in einer zentralen Datenbank zusamengefaßt, gespeichert und dort gegebenenfalls auch bearbeitet werden. Über bidirektionale Datenverbindungen können nun die verschiedensten Datenbenutzer auf die gespeicherten Daten zurückgreifen und diese Daten für eigene Zwecke weiterverwenden. So lassen sich beispielsweise Herstellungszahlen einzelner Produkte oder ganzer Produktbereiche abrufen, Statistiken erstellen, Kosten berechnen, Ausbeuten ermitteln und dergleichen mehr. Derartige Informationssysteme sind bekannt und im industriellen Fertigungsbereich für die unterschiedlichsten Produktionszweige nahezu unerläßlich geworden. Der Zugriff der einzelnen Datenbenutzer auf die Datenbank erfolgt über ein Terminal oder einen Personal-Computer, mit denen nahezu jeder Arbeitsplatz sowieso ausgerüstet ist und die zum Datenaustausch über ein Datennetz elektronisch miteinander verbunden sind.

Aus der Fachzeitschrift "Advances in Instrumentation and Control", Band 48, Teil 3, 01. Januar 1993, Seiten 1557 bis 1564 ist unter dem Titel: "Remote Maintenance Function For Distributed Control System" von Naoki Ura et al ein Informationssystem für Datenverarbeitungseinrichtungen beschrieben, das deren Ferndiagnose und Fernüberwachung dient. Derartige Datenverarbeitungseinrichtungen sind meist an weit auseinanderliegenden Orten aufgestellt, so daß im Störungsfall eine rasche Störungsbeseitigung vor Ort nicht möglich ist. Wenn hierzu auch noch Ersatzteile bestellt werden müssen, dann wird der Aufwand noch größer, weil zunächst einmal die Ausfallursache festgestellt werden muß, bevor das Ersatzteil bestellt werden kann. Eine wesentliche Verbesserung stellt hier das beschriebene Ferndiagnosesystem dar, das auch eine Früherkennung möglicher Ausfälle beschreibt. Die Überwachung erfolgt durch die jeweilige Datenverarbeitungseinrichtung selbst oder durch eine Zentralstation, die über eigene oder öffentliche Datenverbindungen mit den einzelnen Datenverarbeitungseinrichtungen in Verbindung steht. Für die Diagnose können spezielle Testprogramme verwendet werden. Kritische Betriebsparameter, z.B. die Temperatur an bestimmten Stellen im Gerät, werden für die Früherkennung ausgewertet, wobei eine Grenzwertüberschreitung eine Alarmmeldung in der Zentralstation auslöst.

Aufgabe der Erfindung ist es, ein derartiges Informationssystem bei einer Produktionskontrolle zu verwenden, um die Produktionskontrolle schneller und effektiver zu machen.

Die Lösung dieser Aufgabe erfolgt durch die im kennzeichnenden Teil des Anspruchs 1 angegebene Merkmale.

Vorteilhafte Weiterbildungen ergeben sich aus den abhängigen Ansprüchen 2 bis 4. Der Grundgedanke der Erfindung besteht darin, daß die in der Datenbank gespeicherten Daten in speziellen Auswerteeinrichtungen mittels einer Vielzahl von programmierbaren Testprofilen analysiert werden. Dabei unterscheiden sich die Testprofile von den üblicherweise verwendeten Test- und Meßverfahren dadurch, daß im Vordergrund nicht das einzelne Bauelement und die Erfüllung der elektronischen Spezifikationen steht, sondem verstärkt das Prüfumfeld und die verschiedenen Herstellungsschritte. Bei der Überschreitung vorgegebener Grenzwerte der Testprofile wird sofort eine elektronische Meldung an mindestens eine dem jeweiligen Testprofil zugeordnete Empfangsstation weitergegeben, um dort eine Überprüfung des jeweiligen Prüf-, Arbeits- oder Prozeßvorganges bei den laufenden und/oder nachfolgende Produktionsserien einzuleiten.

Der Vorteil der Erfindung besteht darin, daß die Meldungen in den Auswerteeinrichtungen so formatiert werden, daß die Meldungen gezielt über ein elektronisches Briefkastensystem an beliebige Terminals oder Personal-Computer weitergegeben werden können. Da elektronische Briefkastensysteme sehr flexibel und in der Regel für andere Verwendungszwecke bereits installiert sind, ist ihre Verwendung für das verbesserte Informationssystem nach der Erfindungäußerst effektiv. Ein derartiges Briefkastensystem ist beispielsweise "cc:Mail for Windows" von "Lotus" (beide Namen sind als Warenzeichen eingetragen), aber auch andere Briefkastensysteme stehen zur Verfügung oder sind für die üblichen Datennetze und angeschlossenen Stationen erwerbbar. Die schnelle Auswertung und Rückmeldung der Testinformationen ist dort wichtig, wo die Prüfbedingungen kritisch sind und relativ große Prozeßschwankungen vorliegen. Dies ist insbesondere bei der Herstellung von monolithisch integrierten Halbleiterschaltungen der Fall, die wegen der Vielzahl der aufeinanderfolgenden Prozeßschritte eine relativ hohe Fehlerrate zur Folge hat, so daß jede Verbesserung der Ausbeute eine wichtige Rolle spielt. Ein wichtiger Schritt zur Erhöhung der Ausbeute besteht darin, daß nach der Erfindung die aufgrund der gemessenen Daten ausgelösten Meldungen möglichst rasch und genau an die zuständigen Stellen erfolgen, damit die entsprechenden Maßnahmen unverzüglich durchgeführt werden. Dies ist auch dann von Vorteil, wenn die auftretenden Fehler nicht offensichtlich sondern mehr oder weniger versteckt sind, weil dann weitere Analysen durch eine sachkundige Person rasch eingeleitet werden können, um schließlich eine Abhilfe zu finden.

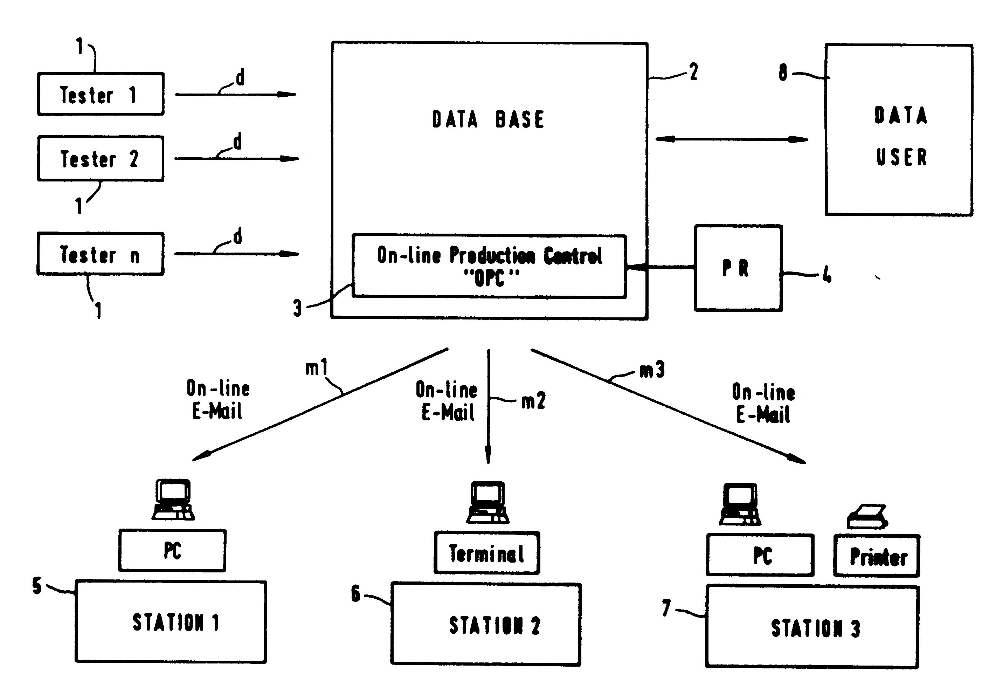

Die Erfindung wird nun anhand der Figur näher erläutert. Die Figur stellt ein Blockschaltbild des Informationssystems dar. Auf der linken Seite befinden sich die Meß- und Testeinrichtungen 1, die produkt- und herstellungsspezifische Daten d ermitteln und an eine Datenbank 2 weitergeben. Dort werden auf übliche Weise die Daten gesammelt und aufgearbeitet, so daß Informationen über Einzelprodukte, Produktionslose, Produktionsserien oder ganze Produktionsfamilien usw. zur Verfügung stehen. Diese Informationen sind von beliebigen Datenbenutzern 8 abrufbar oder werden automatisch an diese weitergegeben.

Mittels einer Programmiereinrichtung 4 wird eine in der Datenbank 2 enthaltene und/oder mit ihr gekoppelte Auswerteeinrichtung 3 installiert. In der Auswerteeinrichtung 3 werden die gespeicherten Daten mittels einer Vielzahl von programmierbaren Testprofilen analysiert. Bei Überschreitung vorgegebener Grenzwerte wird sofort eine elektronische Meldung ml, m2, m3 an eine dem jeweiligen Testprofil zugeordnete Empfangsstation 5, 6, 7 gesendet, wobei den Empfangsstationen 5, 6, 7 genau definierte Arbeitsbereiche und Personen zugeordnet sind. Wird beispielsweise festgestellt, daß ein Tester in einem Endprüfbereich nur noch defekte Bauelemente mißt, dann liegt der Verdacht nahe, daß entweder der Endtester defekt ist oder falsche Bauelemente zugeführt wurden. Ein geeignetes Testprofil kann entsprechende Meldungen ml an die Empfangsstation 5 im Endprüfbereich abgeben. Dadurch wird zunächst die Überwachungsperson aktiviert. Zum anderen kann über die Meldung ml auch der fragliche Tester direkt angesteuert werden, um dort den Meßvorgang zu ändern. Über diese neue Daten kann die Auswerteeinrichtung 3 den Fehler weiter eingrenzen und den Endprüfbereich 5 gezielter auf den Fehler hinweisen.

Beispielsweise ist eine andere, häufige Fehlerquelle bei der Halbleiterherstellung speziellmit der Messung der Wafer-Scheiben, die auch als Proben bezeichnet wird, verbunden. Die Messung am einzelnen Halbleiterkristall erfolgt dabei mittels sehr feiner Nadeln, die auf winzige Kontaktflächen des Halbleiter-Chips aufgesetzt werden. Durch unterschiedliche Dicken der Wafer-Scheiben oder durch eine Vielzahl anderer Ursachen treten häufig Kontaktprobleme auf, die schnell erkannt werden müssen, um nicht gute Bauelemente als schlechte zu deklarieren.

Beim Proben oder Endmessen können aber auch solche Fehler festgestellt werden, die nur als systematische Abweichungen von vorgegebenen Wertebereichen, aber noch innerhalb der Toleranzgrenzen liegend, erkennbar sind und darauf schließen lassen, daß einer der Herstellungsprozesse aus seinem Sollbereich herausgewandert ist. Eine derartige Drift kann sich aber auch bei einem Meßverfahren einstellen, so daß schließlich gute Elemente als fehlerhaft gemessen werden oder gar nur noch Ausschuß festgestellt wird. In jedem Fall ist es äußerst wichtig, daß schnell eine Meldung m2 an die Empfangsstation 6 des entsprechenden Vor- oder Zwischenbereichs erfolgt, möglichst unter Angabe des vermuteten Schwachpunktes, damit eine Kontrolle stattfinden kann, um nachfolgende Serien wieder korrekt zu prozessieren oder zu messen. Das Testprofil schließt hier z.B. die Messung von Abbruchspannungen, Impulszeiten, Stromverstärkungen, Stromaufnahme, Widerstandswerte usw. ein.

Schließlich gibt es ähnliche Testprofile, die durch die Auswahl der einzelnen Messungen insbesondere erkennen lassen, daß die Meßgrenzen unnötig eng sind oder bestimmte Ausfallursachen nicht richtig erfassen können. Derartige Testprofile, die unter Umständen sehr aufwendig sein können, ermöglichen Analysen und daraufhin Optimierungen. Hiermit lassen sich versteckte Fehler oder Abweichungen erkennen, die nicht ohne weiteres durch einen Operator zu beseitigen sind. Durch diese mehr allgemeinen Informationen, die über eine Meldung m3 signalisiert werden, wird z.B. über eine dritte Empfangsstation 7 hauptsächlich ein Ingenieurbereich angesprochen, der daraufhin die Meß- und Prüfprogramme analysieren und gegebenenfalls modifizieren muß. Die Meldung m3 enthält dabei gegebenenfalls weitere Informationen, die die jeweilige Dringlichkeitsstufe erkennen lassen. Da der Ingenieurbereich 7 selbstverständlich auch als Datenbenutzer 8 Zugriff auf die Datenbank 2 hat, kann er dort weitere Infomationen abfragen, um sich eine besseres Bild über die erforderlichen Maßnahmen zu verschaffen. Im Ingenieurbereich 7 wird der Vorteil des Briefkastensystems durch die gezielte Meldung m3 besonders deutlich. Denn dieser Bereich 7 ist in der Regel relativ weit von den eigentlichen Meß- und Testeinrichtungen 1 entfernt und zudem mit dem aktuellen Meßgeschehen meist nicht unmittelbar befaßt. Daher ist es wichtig, daß die zuständige Person sicher und schnell erreichbar ist. Bekannte elektronische Briefkastensysteme leisten dies bestens über ihre speziellen Befehle und Eigenschaften, wie z.B. Adressierung, Adressenumleitung, Adressenweitergabe, Gruppenadressierung und dergleichen mehr, wobei der Inhalt der jeweiligen Meldung m1, m2, m3 frei gestaltet werden kann und damit die Übermittlung einer bloßen Information, aber auch die Übermittlung von Befehlen für Datenverarbeitungs- oder Steuereinrichtungen, enthalten kann.

## Patentansprüche

1. Informationssystem mit
- räumlich auseinanderliegenden Einrichtungen (1) zur Erfassung von Daten (d),
- einer Datenbank (2), die mit internen oder externen Auswerteeinrichtungen (3) zur Auswertung dieser Daten (d) mittels einer Vielzahl von programmierbaren Testprofilen verbunden ist, und
- Empfangsstationen (5, 6, 7), die von der Datenbank (2) eine Meldung (ml, m2, m3) erhalten, wenn bei der Auswertung der Daten (d) vorgegebene Grenzwerte in den Testprofilen überschritten werden,
dadurch gekennzeichnet, daß
- das Informationssystem einer Produktionseinrichtung, insbesondere für die Herstellung von monolithisch integrierten Halbleiterschaltungen, zugeordnet ist und eine Produktionskontrolle ermöglicht,
- die Einrichtungen (1) der Erfassung produkt- und herstellungsspezifischer Daten (d) dienen und
- die Empfangsstationen (5, 6, 7), denen genau definierte Arbeitsbereiche und Personen zugeordnet sind, und die Datenbank (2) über ein elektronisches Briefkastensystem eines Datennetzes miteinander verbunden sind, wobei zwischen den Meldungen (m1, m2, m3), den Empfangssation (5, 6, 7) und den Testprofilen eine derartige Zuordnung besteht, so daß über die jeweiligen Empfangsstationen diejenigen Personen angesprochen werden, die daraufhin eine Überprüfung des jeweiligen Prüf-, Arbeits- oder Prozeßvorganges bei den laufenden und/oder nachvolgenden Produktionsserien durchführen müssen.

2. Informationssystem nach Anspruch 1, dadurch gekennzeichnet, daß mindestens eine erste Empfangsstation (5) über ein erstes Testprofil einer Produkt-Endmeßeinrichtung zugeordnet ist und für diese eine sofortige Kontrolle auslöst.

3. Informationssystem nach Anspruch 1 oder 2, dadurch gekennzeichnet, daß mindestens eine zweite Empfangsstation (6) über ein zweites Testprofil einer Vor- und/oder Zwischenproduktmeßeinrichtung zugeordnet ist und eine sofortige Kontrolle für den zugehörigen Produktionsbereich auslöst.

4. Informationssystem nach einem der Ansprüche 1 bis 3, dadurch gekennzeichnet, daß mindestens eine dritte Empfangsstation (7) über ein drittes Testprofil einer Produkt-Endmeßeinrichtung und/oder einer Vor- und/oder Zwischenproduktmeßeinrichtung zugeordnet ist und eine sofortige Kontrolle in einem Ingenieurbereich, der für den jeweiligen Produktionsbereich und /oder für die Erstellung der einzelnen Prüfprogramme und/oder Testprofile zuständig ist, auslöst.

## Claims

1. An information system comprising
- spatially separated facilities (1) for collecting data (d),
- a data base (2) connected to internal or external analyzing facilities (3) for analyzing said data (D) by means of a plurality of programmable test profiles, and
- receiving stations (5, 6, 7) which receive a message (ml, m2, m3) from the data base (2) if during the analysis of the data (d), predetermined limit values in the test profiles are exceeded,
characterized in
- that the information system is associated with a production facility, particularly a facility for the production of semiconductor monolithic integrated circuits, and permits production control,
- that the facilities (1) serve to collect product- and production-specific data (d), and
- that the receiving stations (5, 6, 7), to which precisely defined areas of work and persons are assigned, and the data base (2) are interconnected via an electronic-mail system of a data network, with the messages (m1, m2, m3), the receiving stations (5, 6, 7), and the test profiles being associated with one another in such a manner that via the respective receiving stations those persons are addressed who then have to check the respective test or process step in the current and/ or subsequent production runs.

2. An information system as claimed in claim 1,
characterized in that at least one first receiving station (5) is assigned to a final test facility via a first test profile and initiates an immediate check for said final test facility.

3. An information system as claimed in claim 1 or 2, characterized in that at least one second receiving station (6) is assigned to a preliminary and/or intermediate test facility via a second test profile and initiates an immediate check for the associated production department.

4. An information system as claimed in any one of claims 1 to 3, characterized in that at least one third receiving station (7) is assigned to a final test facility and/or a preliminary and/or intermediate test facility via a third test profile and initiates an immediate check in an engineering department responsible for the respective production department and/or for creating the individual test programs and/or test profiles.

## Revendications

1. Système d'information comportant
- des installations (1) disposées dans des lieux séparés les uns des autres et destinées à la saisie de données (d),
- une banque de données (2), qui est reliée avec des installations internes et externes de traitement (3) pour le traitement de ces données (d) au moyen d'une pluralité de profils de test programmables, et
- des stations de réception (5, 6, 7), qui reçoivent une annonce (m1, m2, m3) provenant de la banque de données (2) lorsque, lors du traitement des données (d), des valeurs limites prédéterminées sont dépassées dans les profils de test,
caractérisé en ce que
- le système d'information est associé à une installation de production, destinée en particulier à la fabrication de circuits intégrés monolithiques à semi-conducteur et permet un contrôle de la production,
- les installations (1) servent à la saisie de données (d) spécifiques à la production et à la fabrication et
- les stations de réception (5, 6, 7), auxquelles sont associées, de manière précise, des zones de travail et des personnes définies, et la banque de données (2) sont reliées entre elles par l'intermédiaire d'un système électronique de boîtes à lettre d'un réseau informatique, dans lequel, entre les annonces (m1, m2, m3), les stations de réception (5, 6, 7) et les profils de test, il existe une association telle que, par l'intermédiaire des stations de réception respectives, on s'adresse aux personnes qui doivent ensuite réaliser un examen du processus respectif d'essai, de travail ou de procédé lors des séries de production en cours et/ou suivantes.

2. Système d'information selon la revendication 1, caractérisé en ce qu'au moins une station de réception (5) est associée, par l'intermédiaire d'un premier profil de test, à une installation de mesure finale de produit et déclenche un contrôle instantané pour cette dernière.

3. Système d'information selon la revendication 1 ou 2, caractérisé en ce qu'au moins une station de réception (6) est associée, par l'intermédiaire d'un deuxième profil de test, à une installation de mesure de produit initiaux et/ou intermédiaires et déclenche un contrôle instantané pour la zone de production correspondante.

4. Système d'information selon l'une quelconque des revendications 1 à 3, caractérisé en ce qu'au moins une station de réception (7) est associée, par l'intermédiaire d'un troisième profil de test, à une installation de mesure finale de produit et/ou à une installation de mesure de produit initiaux et/ou intermédiaires et déclenche un contrôle instantané dans une zone d'ingénieur, qui est compétente pour la zone de production respective et/ou pour l'établissement des programmes de test et/ou des profils de test particuliers.
